# EUROPEAN PATENT APPLICATION

(11) **EP 1 737 033 A1**
(43) Date of publication of application: **27.12.2006**
(21) Application number: 05730478.4
(22) Date of filing: 13.04.2005
(51) Int. Cl.: H01L 21/8247, H01L 27/115, H01L 29/788, H01L 29/792

(54) **NONVOLATILE SEMICONDUCTOR STORAGE ELEMENT HAVING HIGH CHARGE HOLDING CHARACTERISTICS AND METHOD FOR FABRICATING THE SAME**

(30) Priority: 16.04.2004 JP 2004121837; 26.04.2004 JP 2004129840; 07.02.2005 JP 2005030859; 07.02.2005 JP 2005030860
(71) Applicant: Asahi Glass Company, Limited, Chiyoda-ku, Tokyo 100-8405 (JP); Koyanagi, Mitsumasa, Natori-shi, Miyagi-ken 981-1245 (JP)
(72) Inventor: KOYANAGI, Mitsumasa, Natori-shi, Miyagi 981-1245 (JP); TAKATA, Masaaki, c/o Asahi Glass Company, Limited, Tokyo 100-8405 (JP)
(74) Representative: Müller-Boré & Partner Patentanwälte
(86) International application number: PCT/JP2005/007182
(87) International publication number: WO 2005/101488

(57) **Abstract**

A conventional floating gate type nonvolatile semiconductor memory device had low charge retention characteristic. In order to improve this, the thickness of the tunnel insulating film and the thickness of the gate oxide film were increased sufficiently. As a result, however, there caused difficult problems in obtaining a fast operation speed and a highly dense memory capacity.

In order to solve the above-mentioned problems the nonvolatile semiconductor memory device of the present invention employs for the floating gate for retaining electric charges, a material having a high work function or a high electron affinity, or a material having a small difference of work function with respect to the semiconductor substrate or the control gate, and for the insulating matrix, an amorphous material having a small electron affinity. Further, the proportion of the material for nano-particles to the material for the insulating matrix to be supplied when the charge retention layer is formed, e.g., the mixture ratio of the materials constituting two phases as targets in a sputtering method is adjusted, and the space distance between the outer shells of adjacent nano-particles is optimized, whereby the charge retention characteristic of the floating gate type nonvolatile semiconductor memory device under circumstance of the room temperature or an elevated temperature can be improved; the rewriting performance and multi-value memorizing operations can be stabilized, and the above-mentioned problems on the conventional nonvolatile semiconductor memory device can be solved.

## Description

### TECHNICAL FIELD

The present invention relates to a nonvolatile semiconductor memory device and a process for manufacturing the same, specifically, a structure that nano-particles comprised of at least one type of single-element substance or chemical compound are dispersed with high density in an insulating matrix. Further, it relates to a nonvolatile semiconductor memory device having a charge retention layer of excellent retention characteristic obtained by optimizing the work function or the electron affinity of the nano-particles and the insulating matrix, or by optimizing the space distance between the outer shells of adjacent nano-particles, and a method for producing the device at a low cost and with good reproducibility.

### BACKGROUND ART

Conventionally, as recording media that can record and rewrite a large volume of data, memory devices employing a semiconductor, such as DRAMs or SRAMs, and rotating disk type recording media, such as hard disks, magnetic optical disks or an optical disks, have been available. Further, systems employing any one of the recording media have been developed and used. Among these recording media, DRAMs being capable of increasing writing and reading speed of data and facilitating high integration have been broadly employed as temporary memory devices for a personal computer or the like. However, they have volatility (that is, stored data are lost when power supply from an external power source is stopped) that is fatal in memory devices, and accordingly, it is necessary to supply power from an external power source in order to retain recorded data, whereby power consumption increases. This drawback is in particular inconvenient in using a mobile personal terminal device relying on a battery as a power source.

On the other hand, although hard disk systems do not have volatility of data, these systems have created problems of slow writing and reading speed and relatively high power consumption. Further, they have drawbacks of being weak to mechanical vibrations or a mechanical shock because of their structure. These drawbacks are also very inconvenient in using the mobile personal terminal device.

With the expansion of the market for the mobile personal terminal device in recent years, there has been expected for a memory medium of easy-to-use for the mobile personal terminal device, wherein the memory medium has features of nonvolatility, high memory density, fast writing and reading speed, being capable of operating stably even by mechanical vibrations or a shock when it is carried, requiring low power consumption, and being easily manufactured at a low cost by using a conventional semiconductor manufacturing technique.

As memory media satisfying the above-mentioned requirements, nonvolatile semiconductor memory devices, such as flash memory, ferroelectric memory, MRAM (magnetoresistive random access memory) and phase change memory, have been developed or are partially in practical use.

Each of these nonvolatile memories has advantages and disadvantages respectively. For example, MRAM has many merits, such as fast writing speed and being rewritable many times, and therefore, it has been said to be one of the leading candidates as a replaceable memory for DRAM. However, as the basic structure of this memory medium, it is composed of two components: a transistor and a magnetoresistive element, which make the structure fairly complicated, require strictly a small fluctuation on the thickness of the tunnel insulating film of the magnetoresistive element, and require a large current for rewriting because a large external magnetic field is required for reversing the magnetic field as the size of the magnetoresistive element is smaller.

On the other hand, the memory cell of the flash memory is constituted by a single transistor as its basic structure, and the cell size can be reduced because of its simple structure. Further, a highly integrated memory can be produced at a relatively low cost by employing a conventional DRAM technology. For such reasons, there have already been a large market for the flash memory as for the mobile personal terminal device. Recently, it has been promoted to operate semiconductor devices much faster and to fabricate semiconductor cells to be highly integrated. Being affected by this trend, research has actively been conducted for providing flash memories with high performance, such as miniaturization, fast operation speed or an improvement of charge retention characteristic.

When a NOR flash memory is given as an example as broadly marketed flash memory, the operation of reading data stored in a designated memory cell is rapidly carried out in a relatively short time of about 100 ns (nanosecond) or less.

On the other hand, data are written by channel hot electron (CHE) injection from a channel to a floating gate. And, data are erased by discharging electric charges effected by a Fowler-Nordheim (FN) tunneling current from the floating gate to a channel forming region or a source region. The CHE injection is fast in terms of charge transfer speed, but low in terms of charge injection efficiency (the ratio of an injection current to a supply current). Further, the discharge of charges by the FN tunneling current is slow in terms of the charge transfer speed. Accordingly, the both require much time for rewriting.

Specifically, it takes a relatively long time on the order of 1 µs (micro-second) for writing and on the order of from several hundreds of ms (millisecond) to several seconds (second) for erasing. For this reason, it has been difficult to substitute with a high-speed memory such as DRAM, since, although the flash memory is relatively easy to increase the capacity and reduces cost, the application to the flash memory is limited.

In order to shorten the rewriting time to overcome such drawback, it is considered to reduce the physical thickness of the tunnel insulating film which affects largely time for rewriting, for example. However, if the thickness of the oxide film as the tunnel insulating film is reduced, a very strong electric field in inverse proportion to the thickness of the tunnel insulating film is applied to it at the time of charging the floating gate. Accordingly, when rewriting operations are repeatedly conducted, electric charges transmit through the oxide film many times whereby a stress is resulted in the oxide film so that the oxide film is likely to cause dielectric breakdown.

If the dielectric breakdown occurs at any location in the tunnel insulating film, most charges retained in the floating gate leak out, and the memory cell loses the data retention ability afterward. Therefore, since there is not other choice to be taken but to increase the thickness of the tunnel insulating film in order to obtain the reliability on charge retention at present, and it is difficult to shorten the time of rewriting. Further, according to the law that the thickness of the oxide film and the size of the cell as a whole decrease in similarity, and accordingly, the miniaturization of the entire cell size is also hampered.

With the trend of high-density of memory cells, the distance between floating gates of adjacent cells is reduced whereby the capacitive coupling between adjacent floating gates is enhanced. Accordingly, it is pointed out that erroneous operation is likely to take place at the time of reading or writing. This capacitive coupling affects remarkably in particular in a NAND type flash memory.

For this reason, miniaturization and high density of the currently available bulk-floating-gate type flash memory cell would be difficult rapidly afterward, and the miniaturization of it would reach the limit as early as around the year of 2007.

As means for preventing the charge retention ability from being lowered due to the dielectric breakdown while maintaining high speed performance as well as the reduction of influence by the parasitic capacitance between the floating gates of adjacent cells, there is a method for retaining charges in a spatially discrete manner. As a nonvolatile semiconductor memory according to this method, there is MONOS (metal-oxide-nitride-oxide-semiconductor) memory or a SONOS (in the MONOS memory, metal as the material for the gate electrode is replaced by a semiconductor. Specifically, polycrystal Si is used for the material for the electrode).

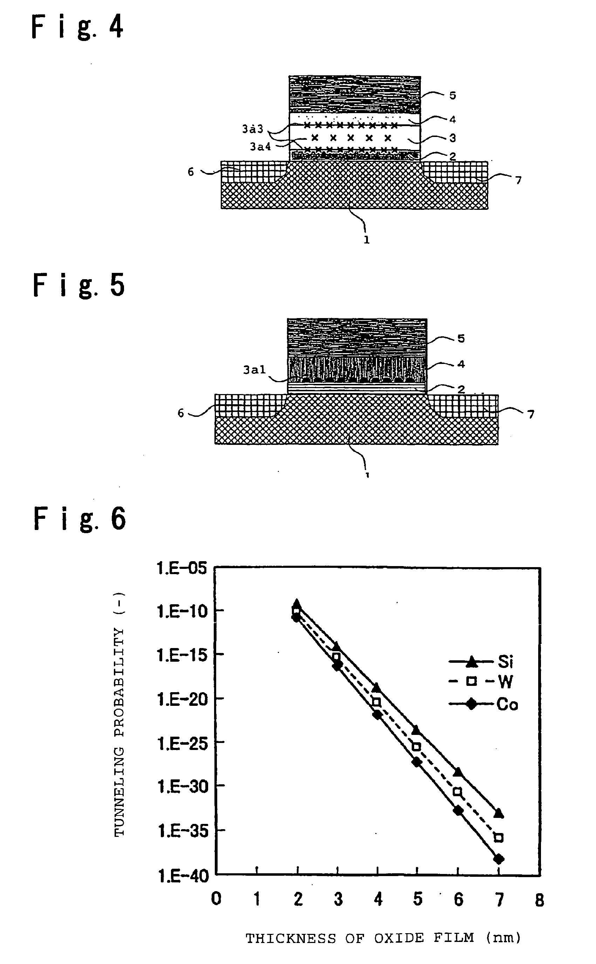

For example, Fig. 4 shows a memory having such a structure comprising a tunnel insulating film 2 and a SiNₓ film as a charge retention layer 3 laminated thereon in place of a floating gate wherein charges are retained at interface level 3a3 at the interface and a trapping level 3a4 distributed discretely in the SiNₓ film. In Fig. 4, reference numeral 1 designates a p-type semiconductor substrate, numeral 4 designates a gate insulating film, numeral 5 designates a control gate electrode, numeral 6 designates a source region and numeral 7 designates a drain region.

Since the interface level 3a3 and the trapping level 3a4, which retain charges, are distributed in a spatially discrete manner, leakage of charge occurs in only a local portion even if dielectric breakdown is resulted at a location in the above-mentioned tunnel insulating film 2. Since, the charge retention ability of the memory cell does not change significantly before and after the occurrence of the dielectric breakdown.

For such reasons, the MONOS memory is more excellent than the currently available bulk-floating-gate type flash memory in terms of the number of times of rewriting and is regarded as being advantageous in terms of miniaturization or the like to the memory cell since the physical thickness of the tunnel insulating film can be made relatively thin. However, the depth of a trapping level in the SiNₓ film (the energy difference between the trapping level and the bottom of the conduction band for an electron, or the energy difference between the trapping level and the top of the valence band for a hole) is not necessarily enough, and accordingly, there is the disadvantage that charges that are once trapped are likely to escape, and therefore, the absolute charge retention ability (the charge retention ability of the cell which is in a normal state without any dielectric breakdown) is low.

On the other hand, as a method for dealing with the problem of the dielectric breakdown of the oxide film by retaining charges in a discrete manner as in the MONOS memory and the problem of capacitive coupling between adjacent floating gates and for enhancing the absolute charge retention ability much more than the MONOS memory, a structure wherein the floating gate is formed by a large number of nano-particles of Si and the Si nano-particles are dispersed in the gate insulating film, has been considered. Fig. 5 shows an example of a semiconductor memory cell having Si nano-particles. In Fig. 5, the same reference numerals as in Fig. 4 except for the Si nano-particles 3a1 designate the same elements as in Fig. 4. A memory having this structure is disclosed in, e.g., JP-A-11-186421. This publication discloses a structure that floating gates composed of a large number of Si nano-particles 3a1 formed by a CVD method is formed on a tunnel insulating film 2, and the floating gate is covered with a gate insulating film 4 as shown in Fig. 5.

When the floating gate is composed of Si nano-particles of intrinsic semiconductor (without containing impurities), injected electrons are trapped at the conduction band level of Si and the height of the potential barrier with respect to the electrons is the difference between the bottom of the conduction band of the oxide film, surrounding the nano-particles and the bottom of the conduction band of Si, namely, the difference on the electron affinity between Si and the oxide film. Since this potential barrier is usually deeper than the barrier formed by the trapping level in the SiNₓ film of the MONOS memory, the trapped electrons are prevented from leaking to the semiconductor substrate or the control gate electrode whereby the charge retention ability becomes higher than that of the MONOS memory.

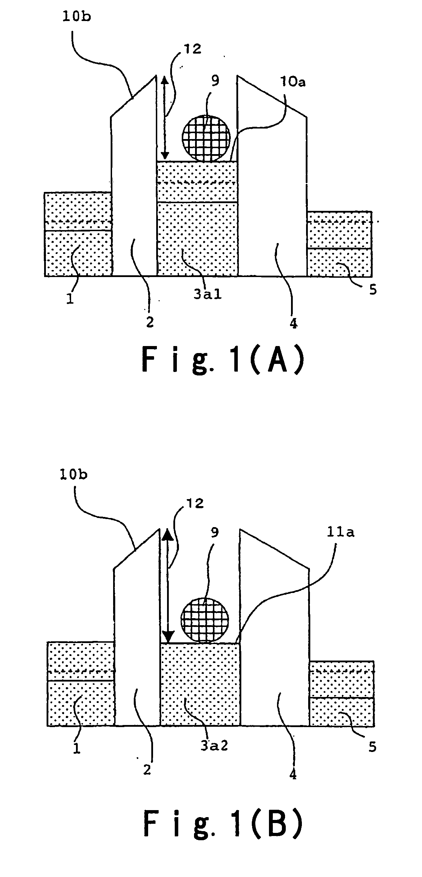

However, in light of the height of the potential barrier, it can not be said that Si is the best material for the nano-particles. Fig. 1(A) is a schematic diagram showing energy level in a state that a Si nano-particle retains an electron. Here, reference numeral 1 designates a p-type semiconductor substrate, numeral 2 a tunnel insulating film, numeral 3a1 a Si nano-particle, numeral 4 a gate insulating film, numeral 5 a control gate, numeral 9 an electron, numerals 10a and 10b designate conduction-band bottom levels of the Si nano-particle and the tunnel insulating film and numeral 12 designates a potential barrier, respectively. The injected electron 9 is trapped at the conduction-band bottom level of the Si nano-particle 10a. In this case, the potential barrier 12 with respect to the electron 9 is the difference between the conduction-band bottom level of the tunnel insulating film 10b and the conduction-band bottom level of Si nano-particle 10a at the interface between the Si nano-particle 3a1 and the tunnel insulating film 2, namely, the difference between the electron affinity of the oxide film and the electron affinity of the Si nano-particle. Fig. 1(B) is a schematic diagram showing energy level in a case that the nano-particle is made of metal. Reference numeral 11a designates a Fermi level of the metal nano-particle, and the same reference numerals as in Fig. 1(A) designate the same elements. In this case, an electron is trapped at the Fermi level of the metal nano-particle 11a. Here, the height of the potential barrier 12 is the difference between the conduction-band bottom level of the tunnel insulating film 10b and the Fermi level of the metal nano-particle 11a at the interface between the metal nano-particle and the tunnel insulating film, namely, the difference between the work function of the metal and the electron affinity of the oxide film. Since the work function of metal generally takes a larger value than the electron affinity of Si, the potential barrier of Si in the oxide film is lower than that in the case of metal. Fig. 6 is a diagram showing probabilities of electrons retained at floating gates of each material of Si, W and Co, tunneling through the SiO₂ film as the potential barrier, the probabilities being obtained by theoretical calculations. The calculations were conducted under assumptions that the electron affinity of Si was 4.1 eV, the work functions of W and Co were respectively 4.6 eV and 5.0 eV and the electron affinity of SiO₂ was 1.0 eV. Accordingly, the heights of potential barriers with respect to electrons retained at the floating gates made of each material of Si, W and Co are 3.1 eV, 3.6 eV and 4.0 eV, respectively. Further, the abscissa of the graph represents the thickness of the tunnel insulating layer of the SiO₂ film through which the electrons transmit. According to these results, the tunneling probability in using the Si floating gate is about 2 to 5 digits higher than the case of using W or Co for the metal floating gate. Namely, it is understood that the leak current from the Si floating gate is 100 to 100,000 times larger than the leak currents from the metal floating gates. The result can be explained based on the difference of the height of the potential barrier in respective cases of Si, W and Co, and shows that the charge retention ability can be increased by using a metallic material having a larger work function than the electron affinity of Si. This effect can also be obtained even in circumstances of high temperature as well. Thus, the method of using metal, not Si, as the material for the floating gate in order to obtain a high charge retention characteristic, is disclosed in, for example, JP-A-16-055969.

In the nonvolatile semiconductor memory device disclosed in the above-mentioned publication, however, the density of floating gates is likely to be excessively high so that the distance between adjacent nano-particles comes too close. This state would not necessarily be the best condition when a multi-bits memorizing operation was to be conducted, and there was still room for improvement such as optimization of the distance between adjacent nano-particles acting as a floating gate.

### DISCLOSURE OF THE INVENTION

The present invention is to solve the above-mentioned problem, i.e., a low charge retention characteristic in a conventional flash memory such as a bulk-floating-gate type flash memory, a MONOS memory or a SONOS memory, or a Si-nano-particles-floating-gates type flash memory. The problem raises barriers to solve various problems on the characteristics of the nonvolatile memory device, e.g., difficulty in improving writing and erasing speed of data and difficulty in miniaturizing and high-density-formation of the cells. According to the present invention, these problems can be solved simultaneously by improving the charge retention characteristic under circumstances of the room temperature or an elevated temperature.

It is an object of the present invention to provide a floating-gate type nonvolatile semiconductor memory device having an excellent charge retention characteristic under circumstances of the room temperature or an elevated temperature, and also, a nonvolatile semiconductor memory device allowing miniaturization of the cells, high density and high speed operation, and further a method for producing the nonvolatile semiconductor memory device with good reproducibility.

In consideration of the above-mentioned points, the features in some aspects of the present invention are as follows.
1. A nonvolatile semiconductor memory cell comprising a source region and a drain region formed on a surface of a semiconductor substrate, a channel forming region formed to connect the source region to the drain region, or formed between the source region and the drain region, a tunnel insulating film formed in contact with the channel forming region, a charge retention layer formed adjacent the tunnel insulating film, a gate insulating film formed adjacent the charge retention layer and a control gate formed adjacent the gate insulating film, characterized in that the charge retention layer comprises an insulating matrix containing a single nano-particle of conductive substance per nonvolatile semiconductor memory cell or a plurality of nano-particles of conductive substance independently dispersed with a density of from 10⁺¹² to 10⁺¹⁴ particles per square centimeter of the charge retention layer, said nano-particle being made of at least one type of single-element substance or chemical compound that functions as floating gate and having a particle size of at most 5 nm, wherein the insulating matrix is amorphous and has an electron affinity of at most 1.0 eV and the work function of the nano-particle of conductive substance is at least 4.2 eV.
   With this structure, the dispersion density, particle size etc. of nano-particles are adequately determined to improve the yield rate of device and the height of the energy barrier with respect to a charge trapped by nano-particle can be adequately determined by selecting materials for the nano-particle and the insulating matrix, whereby the charge retention ability under circumstances of the room temperature or an elevated temperature can be improved in comparison with a conventional device. Or, it is possible to reduce the physical thickness of the tunnel insulating film and the gate insulating film while the charge retention characteristic under circumstances of the room temperature or an elevated temperature can be kept to the same level as the conventional device by determining adequately the energy barrier, whereby the nonvolatile semiconductor memory device capable of increasing data-writing/erasing speed and miniaturizing the cell and allowing integration with high density, can be obtained.
2. The nonvolatile semiconductor memory cell according to the above-mentioned paragraph 1, wherein the difference between the work function of the nano-particle and the work function of the semiconductor substrate is at most 0.5 eV.
3. The nonvolatile semiconductor memory cell according to the above-mentioned paragraph 1 or 2, wherein the difference between the work function of the nano-particle and the work function of the control gate is at most 0.5 eV.
4. The nonvolatile semiconductor memory cell according to the above-mentioned paragraph 1, 2 or 3, wherein the space distance between the outer shells of adjacent nano-particles is from 1 to 5 nm.
   Here, the outer shells indicate the outer surfaces of the nano-particles, in other words, interfaces between the nano-particles and the insulating matrix. Further the space distance between the outer shells indicates the shortest distance between the outer surface of a nano-particle and the outer surface of another nano-particle located adjacently at the shortest distance to the former nano-particle.
5. The nonvolatile semiconductor memory cell according to any one of the above-mentioned paragraphs 1 to 4, wherein the melting point of the nano-particle is at least 1,400°C.
6. The nonvolatile semiconductor memory cell according to any one of the above-mentioned paragraphs 1 to 5, wherein the difference in absolute value between the ionization energy level of an atom constituting the nano-particle in the semiconductor substrate and the energy level at the center of the forbidden band of the semiconductor substrate is at least 0.1 eV.
7. The nonvolatile semiconductor memory cell according to any one of the above-mentioned paragraphs 1 to 6, wherein the nano-particle is at least one type of single substance or chemical compound selected from the group of elements consisting of W, Mo, Ti, Pt, Pd, Ni, Ta, Cr, Os, Nb, Ru and Rh.
   With this structure, the nano-particle satisfying all physical conditions in the above-mentioned paragraphs 1, 5 and 6 provided that a Si monocrystal is used for the semiconductor substrate, can be obtained. Accordingly, it is possible to obtain such a device being excellent in the charge retention characteristic, preventing nano-particles from melting or diffusing even under circumstances of an elevated temperature in manufacturing or using, and preventing the atoms constituting nano-particles from being the recombination centers of carriers even though the atoms diffuse into the semiconductor substrate, hence, providing a stable operation.
8. The nonvolatile semiconductor memory cell according to any one of the above-mentioned paragraphs 1 to 7, wherein the insulating matrix constituting the charge retention layer is made of at least one type of chemical compound selected from the group consisting of an oxide, a carbide, a nitride, a boride, a silicide and a fluoride.
9. The nonvolatile semiconductor memory cell according to any one of the above-mentioned paragraphs 1 to 8, wherein the nano-particles constituting the charge retention layer are dispersed two-dimensionally or three-dimensionally in the insulating matrix.
10. A method for producing a nonvolatile semiconductor memory cell comprising the charge retention layer as described in the above-mentioned paragraph 9, in which nano-particles are dispersed two-dimensionally or three-dimensionally in the insulating matrix, characterized in that the charge retention layer is formed in a manner of self-organization by using a physical deposition method for depositing materials for the nano-particles and the insulating matrix respectively.
11. The method for producing a nonvolatile semiconductor memory cell according to the above-mentioned paragraph 10, wherein the physical deposition method is a sputtering method.
12. A nonvolatile semiconductor memory cell comprising a source region and a drain region formed on a surface of a semiconductor substrate, a channel forming region formed to connect the source region to the drain region, or formed between the source region and the drain region, a tunnel insulating film formed in contact with the channel forming region, a charge retention layer formed adjacent the tunnel insulating film, a gate insulating film formed adjacent the charge retention layer and a control gate formed adjacent the gate insulating film, characterized in that the charge retention layer comprises an insulating matrix containing a single nano-particle of semiconductor material or insulating material per nonvolatile semiconductor memory cell or a plurality of such nano-particles independently dispersed with a density of from 10⁺¹² to 10⁺¹⁴ particles per square centimeter of the charge retention layer, said nano-particle being made of at least one type of single-element substance or chemical compound that functions as a floating gate and having a particle size of at most 5 nm, wherein the insulating matrix is amorphous and has an electron affinity of at most 1.0 eV and the electron affinity of the nano-particle is at least 4.2 eV.
   With this structure, the dispersion density, particle size etc. of nano-particles are adequately determined to improve the yield rate of device and the height of the energy barrier with respect to a charge trapped by a nano-particle can be adequately determined by selecting materials for the nano-particle and the insulating matrix, whereby the charge retention ability under circumstances of the room temperature or an elevated temperature can be improved in comparison with a conventional device. Or, it is possible to reduce physical thickness of the tunnel insulating film and the gate insulating film while the charge retention characteristic under circumstances of the room temperature or an elevated temperature can be kept to the same level as the conventional device by determining adequately the energy barrier, whereby the nonvolatile semiconductor memory cell capable of increasing data-writing/erasing speed and miniaturizing the cell and allowing integration with high density, can be obtained. Further, the range of selection to material for the nano-particles can be expanded not only to a conductor but also a semiconductor or insulator.
13. The nonvolatile semiconductor memory cell according to the above-mentioned paragraph 12, wherein the difference between the work function of the nano-particle and the work function of the semiconductor substrate is at most 0.5 eV.
   With this structure, the difference between the work function of the nano-particle and the work function of the semiconductor substrate is further limited to at most 0.5 eV whereby the spontaneous flow of charges from the semiconductor substrate to the nano-particles before writing operations can be prevented to thereby effectively lower the energy barrier, in addition to the effect obtained by practicing the invention of the above-mentioned paragraph 2 or 13, i.e., the effect of improving the yield rate to the device or the effect of improving the charge retention characteristic under circumstances of the room temperature or an elevated temperature.
14. The nonvolatile semiconductor memory cell according to the above-mentioned paragraph 12 or 13, wherein the difference between the work function of the nano-particle and the work function of the control gate is at most 0.5 eV.
   With this structure, the difference between the work function of the nano-particle and the work function of the control gate is further limited to at most 0.5 eV whereby the spontaneous flow of charges from the control gate to the nano-particles before writing operations can be prevented to thereby control effectively the lowering of the energy barrier, in addition to the effect obtained by practicing the invention of the above-mentioned paragraph 3 or 14, i.e., the effect of improving the yield rate to the device or the effect of improving the charge retention characteristic under circumstances of the room temperature or an elevated temperature.
15. The nonvolatile semiconductor memory cell according to the above-mentioned paragraph 12, 13 or 14, wherein the space distance between the outer shells of adjacent nano-particles is from 1 to 5 nm.
   With this structure, when the invention of the above-mentioned paragraph 4 or 15 is practiced, the distance between adjacent nano-particles becomes adequate whereby it is possible to increase the insulation between the adjacent nano-particles and it is possible to suppress the movement of charges between adjacent nano-particles. Accordingly, such nonvolatile semiconductor memory cell improving reliability in data-rewriting and multi-bits operations can be obtained in addition to the above-mentioned effects, namely, the improved charge retention ability under circumstances of the room temperature or an elevated temperature, the high-speed operations and high integration.
16. The nonvolatile semiconductor memory cell according to any one of the above-mentioned paragraphs 12 to 15, wherein the melting point of the nano-particle is at least 1,400°C.
   With this structure, when the invention of the above-mentioned paragraph 5 or 16 is practiced, it is possible to prevent the nano-particles from melting or to suppress the atoms constituting the nano-particle from diffusing or dissipating even under the circumstances of an elevated temperature in manufacturing or using the device. Accordingly, the nonvolatile semiconductor memory device capable of improving the yield rate to the device and stabilized operations under circumstances of the room temperature or an elevated temperature can be obtained.
17. The nonvolatile semiconductor memory cell according to any one of the above-mentioned paragraphs 12 to 16, wherein the difference in absolute value between the ionization energy of atoms constituting the nano-particle in the semiconductor substrate and the energy level at the center of the forbidden band of the semiconductor substrate is at least 0.1 eV.
   With this structure, when the invention of the above-mentioned paragraph 6 or 17 is practiced, it is possible to reduce the probability of capturing carriers and to suppress influence to the carrier density even when the atoms constituting the nano-particle diffuse into the semiconductor substrate to form of recombination centers of the carriers so that impurity levels are formed. Accordingly, the nonvolatile semiconductor memory device capable of improving the yield rate to the device and stabilizing operations under circumstances of the room temperature or an elevated temperature, can be obtained.
18. The nonvolatile semiconductor memory cell according to any one of the above-mentioned paragraphs 12 to 17, wherein the insulating matrix constituting the charge retention layer is made of at least one type of chemical compound selected from the group consisting of an oxide, a carbide, a nitride, a boride, a silicide and a fluoride.
   With this structure, when the invention of the above-mentioned paragraph 8 or 18 is practiced, it is possible to select the material for the insulating matrix from a group consisting of an oxide, a carbide, a nitride, a boride, a silicide and a fluoride. Accordingly, the nonvolatile semiconductor memory cell having excellent characteristics such as a high insulation characteristic due to high energy barrier, sufficient heat-resistance characteristic and so on, can be realized.
19. The nonvolatile semiconductor memory cell according to any one of the above-mentioned paragraphs 12 to 18, wherein the nano-particles constituting the charge retention layer are dispersed two-dimensionally or three-dimensionally in the insulating matrix.
   With this structure, when the invention of the above-mentioned paragraph 9 or 19 is practiced, namely, in a case that nano-particles are dispersed two-dimensionally, the thickness of the charge retention layer becomes thin to thereby enhance the capacitive coupling between the semiconductor substrate and the control gate electrode whereby a short-channel effect in a MOSFET (metal-oxide-semiconductor field-effect transistor) can be controlled, and in a case that the dispersion is in a three-dimensional manner, it is possible to obtain multi-bits operations by controlling the distance between the distribution center of retained charges and the semiconductor substrate, or it is possible to confine the charges due to quantization of the nano-particles. Thus, the nonvolatile semiconductor memory cell having the above-mentioned features can be realized.
20. A method for producing a nonvolatile semiconductor memory cell comprising the charge retention layer as described in the above-mentioned paragraph 19, in which nano-particles are dispersed two-dimensionally or three-dimensionally in the insulating matrix, characterized in that the charge retention layer is formed in a manner of self-organization by using a physical deposition method for depositing materials for the nano-particles and the insulating matrix respectively.
   With this structure, when the invention of the above-mentioned paragraph 10 or 20 is practiced, the physical deposition method can provide a thermodynamics state by which phase separation is likely to occur on the insulating matrix and the nano-particles in a manner of self-organization. Accordingly, this method is suitable for forming the charge retention layer of the nonvolatile semiconductor memory cell having the above-mentioned features, and therefore it is possible to obtain such nonvolatile semiconductor memory device.
21. The method for producing a nonvolatile semiconductor memory cell according to the above-mentioned paragraph 20, wherein the physical deposition method is a sputtering method.

With this structure, when the invention of the above-mentioned paragraph 11 or 21 is practiced, the sputtering method categorized in the physical deposition method has particularly excellent features such as excellent adhesiveness to an underlayer, formation of a dense film in which atoms constituting the film are bonded strongly, allowing broad selection for film-forming materials, mass productivity and manufacturing at a low cost. Accordingly, the nonvolatile semiconductor memory cell in which the charge retention layer is preferably formed, can be realized.

### BRIEF DESCRIPTION OF THE DRAWINGS

(Fig. 1) Fig. 1 shows schematic diagrams of energy level for explaining the charge retention characteristic on the nonvolatile semiconductor memory cell of the present invention wherein (A) shows a case that the nano-particle is made of Si and (B) shows a case that the nano-particle is made of metal.
(Fig. 2) Fig. 2 is a schematically cross-sectional view showing the nonvolatile semiconductor memory cell according to Embodiment 1 of the present invention.
(Fig. 3) Fig. 3 is a schematically cross-sectional view showing the nonvolatile semiconductor memory cell according to Embodiment 2 of the present invention.
(Fig. 4) Fig. 4 is a schematically cross-sectional view showing an example of conventional MONOS memory cell.
(Fig. 5) Fig. 5 is a schematically cross-sectional view showing an example of conventional semiconductor memory cell containing Si nano-particles.
(Fig. 6) Fig. 6 is a graph showing the probabilities of electrons retained in each floating gate comprising each material of Si, W and Co, tunneling through a SiO₂ film as the potential barrier, the result being obtained by theoretical calculation.

### BEST MODE FOR CARRYING OUT THE INVENTION

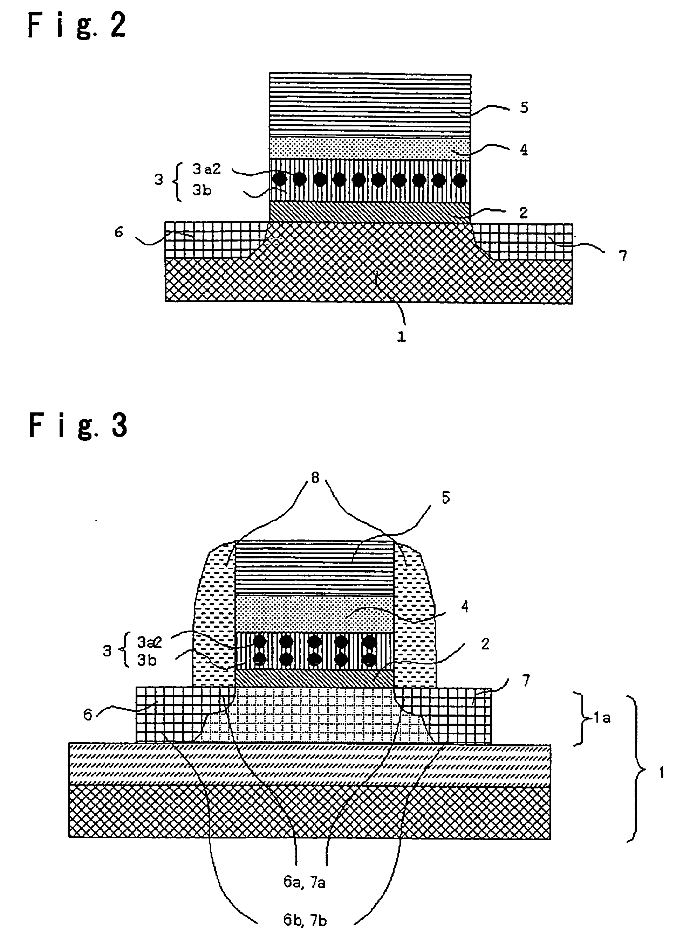

Fig. 2 is a schematically cross-sectional view of an example of the nonvolatile semiconductor memory cell of the present invention. In Fig. 2, reference numeral 1 designates a p-type semiconductor substrate, numeral 2 designates a tunnel insulating film and numeral 3 designates a charge retention layer in which metal nano-particles 3a2 acting as floating gates are contained in a dispersion state in an insulating matrix 3b. Numeral 4 designates a gate insulating film, numeral 5 designates a control gate, numeral 6 designates a source region and numeral 7 designates a drain region.

The p-type semiconductor substrate 1 may be of a semiconductor material in its entirety or may be a semiconductor layer formed on an insulator, such as a SOI substrate. As the tunnel insulating film 2, a silicon oxide film having better boundary matching to the p-type semiconductor substrate 1, a material having a high dielectric constant in order to increase the capacitive coupling ability to the semiconductor substrate under the application of a control gate voltage, e.g., SiOₓN_{y} (0≦x<2 and 0<y≦4/3, where x and y preferably satisfy 2x+3y=4) type material, or HfO₂ may be used preferably.

Further, when a heavy metal is used as the material for the floating gate or control gate, the heavy-metal element diffuses into the semiconductor substrate through the tunnel insulating film to change the threshold voltage of MOSFET. In order to prevent this, an insulating film of nitrogen compound type such as SiNₓ (0<s≦4/3) or a non-Si type oxide such as HfO₂ or LaOₓ is desirably used in order to prevent the metal element from diffusing into the semiconductor substrate.

Further, in order to obtain fast data-writing/erasing operations, the film thickness of the tunnel insulating film should be thin as possible, preferably at most 8 nm. Further, the thickness of at most 5 nm is extremely preferable to obtain high-speed operations.

It is preferred that the metal nano-particles 3a2 constituting the charge retention layer 3 are evenly dispersed with high density in order to suppress influence by the loss of retained charge due to the dielectric breakdown of the tunnel insulating film 2 as possible, or to suppress dispersion of shift quantity of threshold voltage (ΔVₜₕ, referred to as the memory window) of each cell due to the presence or absence of electric charges on the nano-particles. Specifically, it is preferred that a single nano-particle exists per one nonvolatile semiconductor memory cell or nano-particles exist therein with a density of from 10⁺¹² to 10⁺¹⁴/cm². Further, it is preferred that the distance between the outer shells of adjacent nano-particles be broad, specifically at least 1 nm apart from each other, in order to increase insulating performance of the adjacent nano-particles. However, if the distance is too broad, the high-density dispersion can not be obtained. Accordingly, the upper limit of the space distance of outer shells should be 5 nm. Further, in order to satisfy both requirements of the high-density dispersion of the nano-particles and the insulating performance of adjacent particles, the size of a nano-particle is desirably at most 5 nm, more preferably, at most 3 nm. Here, the size of the nano-particle is an averaged value, i.e., an arithmetic average of the sizes of nano-particles excluding each portion of 10% from a larger side and a smaller side in the distribution of particle size.

Basically, the materials for constituting the charge retention layer 3 are selected in combination so that a material for the metal nano-particles 3a2 and a material for the insulating matrix 3b in the charge retention layer 3 cause phase separation when the charge retention layer 3 is formed.

The material for forming the nano-particle-dispersed phase may be any one of metal, semiconductor and insulator. However, a material having a large work function or electron affinity as possible is preferred from the viewpoint of obtaining a high charge retention ability. Accordingly, it is preferred to use the metal as indicated by the numeral 3a2 in Fig. 2. In theoretical explanation, the tunneling probability of electrons separating from the trapping nano-particles and transmitting through the insulator varies depending on a material constituting the nano-particles, and the larger the work function or the electron affinity of the material is, the lower the tunneling probability is, as shown in Fig. 6.

Further, difference in the work function of the material for the floating gate also affects the charge retention ability of the cell in high temperature circumstances depending on materials used. Here, the high temperature circumstances means the temperature region of from about 40°C to the upper limit temperature of about 250°C to 300°C. Under the high temperature circumstances, the thermal energy of a retained charge (the thermal energy assumes a value in proportion to kT where k represents the Boltzmann constant and T represents the absolute temperature) is high in comparison with the circumstances of the room temperature. Accordingly, the effective potential barrier decreases. Further, the energy band gap of the insulator surrounding the floating gates has a relatively large temperature dependence. SiO₂ which is used widely for the insulator shows the tendency that the band gap becomes smaller when the temperature rises, and the influence of a smaller gap with temperature rise is too large to disregard.

Due to the influence by the thermal energy of the retained charge and the reduction of the gap with temperature rise, the potential barrier in the circumstances of an elevated temperature is significantly low in compassion with that in the circumstances of the room temperature, whereby the charge retention ability at an elevated temperature is deteriorated. Accordingly, when metal having a large work function is used for the floating gates, it is possible to compensate sufficiently the effectively lowered potential barrier in the circumstances of an elevated temperature, and the tunneling probability can be controlled to be low in comparison with the case of using Si for the floating gates even in a circumstances of an elevated temperature.

Thus, when a material having a large work function is used for the floating gate, the charge retention ability in the circumstances of an elevated temperature can be increased in comparison with a case that a material having a small work function is used, or a semiconductor material such as Si lowering substantially the potential barrier with temperature rise is used. Specifically, it is preferred that a material having a work function of at least 4.2 eV is used for the metal material and a material having an electron affinity of at least 4.2 eV is used for the semiconductor or insulating material.

As the material of nano-particle-dispersed phase, it is preferred to use a material having a work function as close as possible to that of the semiconductor substrate or the control gate electrode from the viewpoint that a high charge retention ability can be obtained by suppressing electric charges from transmitting to the nano-particles before the writing operation to thereby increase the effective height of the potential barrier. Specifically, it is preferred that the difference in absolute value of the work function between the material of nano-particle-dispersed phase and the material of semiconductor substrate, or the difference in absolute value of the work function between the material of nano-particle-dispersed phase and the material of control gate is at most 0.5 eV, more preferably, at most 0.1 eV.

This is derived from the following reason. When materials of different work functions are joined and they reach a thermal equilibrium state, electrons move from one material to the other so that Fermi levels of both materials agree with each other. Therefore, when, for example, the work function of a nano-particle is excessively high, a powerful force acts on an electron to move it from the semiconductor substrate or control gate to the nano-particle, whereby a state that the electron is spontaneously injected into the nano-particle before the manipulation of injecting an electron into the nano-particle, takes place. In such state, when another electron is to be further injected in order to write data, the second electron or n-th electrons (n≧2) are to be injected in the nano-particle. For convenience of explanation hereafter, the electron injected spontaneously before the writing operation is referred to as "the thermal equilibrium electron", and the electron injected afterward by the writing operation is referred to as "injection electron".

Then, the injection electron suffers the Coulomb blockade by the thermal equilibrium electron. Accordingly, there causes difficulty in being injected into the nano-particle by an amount of electrostatic energy of ΔE_{C}=e²/(2C). Since the injection electron has a higher energy by ΔE_{C}, the height of the potential barrier with respect to the injection electron is lowered by ΔE_{C}. Since it is the injection electron that is manipulated artificially for writing and erasing operations, and mainly acts as a carrier of data to be memorized, such is equivalent to an effective reduction of the potential barrier.

Further, since the nano-particle is of a size of an order of nanometer, the energy level of the electron trapped by the nano-particle is quantized. When a thermal equilibrium electron occupies a lower energy level and an injection electron is trapped at a higher energy level by ΔE_{Q}, it is necessary for the injection electron to give a higher energy by ΔE_{Q} over the energy level of the thermal equilibrium electron whereby it would result that the height of the potential barrier with respect to the trapped injection electron is lowered by ΔE_{Q} in the same as the case of the Coulomb blockade.

In fact, since two effects of Coulomb blockade and quantization exist together, the height of the potential barrier with respect to the injection electron is lowered by the sum of these, i.e., ΔE_{C}+ΔE_{Q} in a simple sense, provided that the interaction of these two effects is ignored. Since such effective reduction of the barrier is caused by injecting beforehand the first electron into the nano-particle, it is important to suppress the spontaneous injection of the thermal equilibrium electron. For this, it is preferred that the work function of the nano-particle is close to the work function of the semiconductor substrate or control gate electrode.

Further, there is a case that the charge retention layer is subjected to a treatment of high temperature in the process of manufacturing the nonvolatile semiconductor memory cell of the present invention. In this case, the nano-particle should have a high melting point in order to avoid the aggregation of nano-particles by heat, specifically, it preferably has a melting point of at least 1,400°C.

Further, when elements forming the nano-particles diffuse to reach the semiconductor substrate, there is a case that an impurity level is formed in the semiconductor substrate depending on an element of nano-particle. When the substrate is made of an indirect transition type semiconductor, a recombination center is created to reduce the lifetime of carrier, whereby it affects the ON current or the threshold voltage of MOSFET. The probability of recombination becomes higher as the impurity level is closer to the gap center of the forbidden band of the semiconductor substrate. Accordingly, use of an element forming an impurity level close to the gap center is undesirable as the element for forming the nano-particle. On the other hand, the probability of recombination decreases exponentially as the impurity level is remoter from the gap center. Accordingly, if the impurity level is formed at a position apart from the gap center to a certain extent, influence to the operation of MOSFET is small even when an impurity level is formed. Accordingly, as the element constituting the nano-particle, it is preferred to use such an element capable of forming an impurity level at a position apart from at least 0.1 eV from the gap center of the semiconductor substrate (although there is no in particular limitation on the upper limit, it is about 0.56 eV in a case that the semiconductor substrate is made of Si, for example. This value depends on the material of semiconductor substrate).

In view of the above-mentioned, it is preferred to select the material of nano-particle in consideration of the work function, the melting point and the impurity level. When Si is used for the semiconductor substrate, it is preferred to use nano-particles made of metal such as W, Mo, Ti, Pt, Pd, Ni, Ta, Cr or the like. However, Os, Re, Nb, Ru or Rh may be used.

The nano-particle of elemental semiconductor is preferably at least one type of Se and Te. Further, it may contain as an impurity at least one type of element of P-, As, Sb, B, Al, Ga, In and Cu in at least one type of semiconductors of Se and Te.

The nano-particle of chemical compound semiconductor or insulator is preferably at least one type of chemical compound selected from the group consisting of InAs, InGaAs, InGaNAs, InAlAs, InAsP, InGaAsP, InSb, InGaSb, InAlSb, InGaAsSb, SiC, Cu₂O, ZnO, CdO, BaO, PbO, NiO, In₂O₃, Sb₂O₃, SnO₂, Ag₂O, AgO, RuO₂, V₃Ga, Nb₃Sn, Nb₃Al, Nb₃Ga, Nb₃Ge, NbTi, NbMo₆S₈, ZnS, CdS, HgS, PbS, Sb₂S₃, Bi₂S₃, ZnSe, CdSe, HgSe, SnSe, PbSe, In₂Se₃, Sb₂Se₃, BiSe₃, ZnTe, CdTe, HgTe, SnTe, PbTe, In₂Te₃, Bi₂Te₃, BN, GaN, InN, TiN, BP, AlP, GaP, InP, Zn₃P₂, Cd₃P₂, ZnP₂, CdP₂, AlAs, GaAs, Zn₃AS₂, Cd₃As₂, ZnAs₂, CdAs₂, AlSb, GaSb, ZnSb, CdSb, Si₃N₄.

Further, in these substances, one containing as an impurity at lease one type of element of Sn, Sb, Ga, Al and In in at least one type of chemical compound of In₂O₃, Sb₂O₃, SnO₂, ZnO and GaAs, may be used.

On the other hand, the material for the insulating matrix may be of either semiconductor or insulator. However, a material having a smaller electron affinity as possible, specifically, a material of at most 1.0 eV is preferred in order to improve the charge retention characteristic. Further, it is preferred to select a material having a high melting point in order to obtain a stable heat treatment in the semiconductor process, specifically, a material having a melting point of at least 1,400°C is preferred.

It is further preferred that the material for the insulating matrix is capable of forming amorphous phase. The reason is that when electrons trapped by the nano-particles transmit through the insulating matrix due to tunneling, the scattering probability of the tunneling electrons by the atoms composing the insulating matrix of amorphous is higher than the case of the insulating matrix of crystalline. As a result, it can be expected that an effective amount of electron leakage due to tunneling decreases. It is very desirable to use a physical vapor deposition method such as a sputtering method as a film forming method for forming a nano-particle-dispersed film in order that the insulating matrix is made amorphous. The insulating matrix of amorphous can easily be obtained because the physical vapor deposition method such as a sputtering method can form the film even at a relatively low temperature.

The material for the insulating matrix in the charge retention layer may be at least one type of chemical compound selected from the group consisting of an oxide such as silica, alumina, titania, mullite, cordierite, spinel, zeolite, forsterite or magnesia, a carbide such as boron carbide (B₄C), a nitride such as silicon nitride, boron nitride or aluminum nitride and a fluoride such as magnesium fluoride or aluminum fluoride.

In order to improve the charge retention ability of the charge retention layer, it is effective to disperse nano-particles in the charge retention layer to have an arrangement of at least two layers, i.e., to have a three-dimensional multi-layered structure. Specifically, the multi-layered structure indicates a structure comprising a layer that nano-particles are arranged on a flat plane parallel to the surface of the semiconductor substrate and another layer having the same arrangement interposing therebetween a thin insulating layer, the first and second layers being laminated alternately. Explanation will be made as to the reason why the multi-layered structure of nano-particles can improve the charge retention characteristic. Assuming that the multi-layered structure comprises two nano-particle layers laminated wherein the layer formed closer to the semiconductor substrate is referred to the first layer and the layer remoter from that is referred to the second layer. In the state that electric charges are retained in both the first and second layers, when electrons in the second layer are about to escape toward the semiconductor substrate, the leakage of the electrons in the second layer toward the substrate is blocked due to an electrostatic potential formed by the electrons of the first layer which exists in the way of the leakage. Accordingly, the charge retention performance of the multi-layered structure is better than the case of a single-layered structure.

The effect that the electrostatic potential formed by charged particles blocks the movement of charged particles existing around the former charged particles and having the same sign of charge as the former charged particles, is called the Coulomb blockade effect. This effect is expressed by a formula ΔE_{C}=e²/(2C) where ΔE_{C} represents an increase of electrostatic potential, i.e., the height of the energy barrier due to the Coulomb blockade, e represents a electric charge of electron and C represents a tunnel junction capacitance with respect to electron movement.

In order to obtain the Coulomb blockade effect in the room temperature, it is essential that an increase ΔE_{C} of electrostatic potential energy is larger than a thermal energy kTᵣ of room temperature where k represents Boltzmann's constant and Tᵣ represents the room temperature. In addition to this, it is necessary to satisfy the condition derived from the uncertainty principle, namely, the condition that the junction resistance R is around R~h/e²≒26kΩ or more, where h represents Plank's constant.

In order to satisfy such required condition and to obtain the Coulomb blockade effect sufficiently, the tunnel junction capacitance should be small. For this, the smaller the size of the nano-particles is, the better.

The following effect can be expected when the size of each nano-particle is small. Since the size of the nano-particle is very small as at most 5 nm, it is easily imaginable that the energy level is discretely distributed. Now, attention is focused on two nano-particles adjacently located in a vertical direction in the first and second layers. It is assumed that states of distribution of energy level of two nano-particles in a charge-free state are equal to each other. Here, when an electric charge is injected only to the nano-particle in the second layer, the energy level of the charged particle is shifted to a higher side with respect to the energy level of the charge-free nano-particles in the first layer. Namely, there appears a relative difference in the height of the distributed energy level of the two nano-particles of attention, and there is a possibility that the nano-particles in the first layer does not have the energy level in agreement with the energy level of the nano-particle in the second layer, in which the injected electron is trapped.

The non-existence of the energy level in agreement prevents the tunnel transmission of the nano-particle, and therefore, the charge on the particle of the second layer is prohibited from leaking toward the semiconductor substrate via the nano-particle in the first layer. This phenomenon does not occur in a bulk material having a continuous distribution of energy level but occurs in a case that the size of each nano-particle is sufficiently small and the distribution of energy level is quantized in a discrete state. Thus, it is possible to suppress the transmission of charges due to the tunnel phenomenon.

The above-mentioned is the explanation from a physical standpoint as to why the charge retention performance of the nano-particles in the multi-layered structure can be improved. In order to obtain the above-mentioned Coulomb blockade effect and the quantization effect effectively, the size of each nano-particle is preferably small as at most 5 nm, more preferably at most 3 nm. Further, in order to make the Coulomb blockade effect uniform spatially, the area density of the nano-particles is preferably higher as from 10⁺¹² to 10⁺¹⁴/cm².

Further, in order to reduce the tunnel junction capacitance and to increase the junction resistance, the space distance between the outer shells of adjacent particles, in this case, the distance between the first layer and the second layer should be wide to a certain extent, and is preferably at least 1 nm. However, if the distance is too large, the distance between the semiconductor substrate and the control gate electrode expands, and in a cell having a small channel length, a short channel effect takes place. Therefore, it is preferred that the upper limit of the space distance between the outer shells be 5 nm.

In the method for producing the charge retention layer in the present invention, the layer is formed in a single process according to a physical film-forming method. The employment of CVD method can be considered as a method for forming a charge retention layer. In the CVD method, however, it is necessary to form the nano-particles and the insulating matrix separately, whereby a complicated process was needed to disperse the nano-particles three-dimensionally in a multi-layered structure. On the other hand, according to the film-forming method of the present invention, the nano-particles and the insulating matrix can be formed simultaneously, and the dispersed structure of the nano-particles can be obtained in a manner of self-organization. Accordingly, this method is very easy and economical. Thus, the method for forming the charge retention layer of the present invention is extremely suitable for forming the above-mentioned multi-layered structure of nano-particles.

In the above-mentioned comparison concerning the method for forming the charge retention layer, further detailed explanation will be made in the following. The CVD method has a following disadvantage in comparison with the physical film forming method. A film of single phase without having separated phases, i.e., a film of equilibrium phase is easily formed because the pressure of a gas phase at the time of forming the film is high; the collision rates of the reactive atomic species and the reactive molecular species are high in the gas phase, and the temperatures of both the gas phase and the substrate surface are high. Accordingly, when the nano-particles and the insulating matrix are separated as in the charge retention layer of the present invention, namely, when a film in a non-equilibrium state or quasi-equilibrium state is formed, use of the chemical vapor deposition method is improper. Further, the number of usable types of material gas applicable to the CVD method is lesser than that to the physical deposition method -such as a sputtering method, in particular, the number of types of the material gas for forming a metal film is limited. Further, the number of combination of gases to be supplied simultaneously into a reactor is further limited. Thus, since there is limitation in using materials for forming the film, the chemical vapor deposition method is also improper from this viewpoint.

On the other hand, in the physical film-forming method, the collision rates of the reactive atoms and reactive molecules for forming a film in a gas phase are low and the temperature of the substrate is low. Accordingly, a film of non-equilibrium state or quasi-equilibrium state like the charge retention layer of the present invention can easily be formed.

As the physical deposition method for forming the charge retention layer, a sputtering method, a thermal vapor deposition method, an electron beam vapor deposition method, a laser ablation method or a molecular beam epitaxy method may be mentioned. In particular, the sputtering method is in particular preferred since it is excellent in mass productivity in addition that a broad selection is possible for film-forming materials; a dense film having a strong interatomic bonding force can be obtained because the incident energy to the substrate is high, and a film having high adhesiveness to an underlayer can be obtained.

Further, the sputtering method is preferred because film-forming conditions adequate for the self-organization in the present invention can be obtained. For example, a sufficiently low gas phase pressure and an appropriate substrate temperature, being not too low and too high can be obtained. Accordingly, a self-organized structure is obtainable by an appropriate migration of the particles as film-forming species on the surface of the substrate.

The self-organization in the present invention means that the atoms constituting the nano-particles and the atoms constituting the insulating matrix are spontaneously dispersed and are arranged regularly due to a thermodynamic interaction and the like, with the result that nano-particles of metal or semiconductor gather systematically in the phase of the insulating matrix. The arrangement of atoms by this self-organization depends on combinations of a material constituting the nano-particles and a material constituting the insulating matrix and the ratio thereof, and film-forming conditions such as electric power for generating plasma, film-forming pressure, substrate temperature and so on.

Further, as a sputtering apparatus, it is preferred to use an apparatus using inductively-coupled plasma (ICP), electromagnetic-wave-coupled plasma (ECR plasma) or a facing target type apparatus because damage to the tunnel insulating film as an underlayer is low. Further, in the above-mentioned film-forming apparatus, it is preferred to use an apparatus having the function of applying an appropriate bias voltage to the film-forming substrate because an incident energy of the film-forming particles to the substrate can be controlled.

When the charge retention layer is formed by the sputtering method, it is necessary to sputter simultaneously material for forming the phase of dispersed nano-particles and material for forming the phase of the insulating matrix. There are a method for preparing separately materials for these phases and sputtering simultaneously a plurality of targets, and a method for sputtering both materials for the phases, mixed on a single target. The latter method is further classified into a technique that a mixture of powdery materials for the both phases is sintered and a technique that an appropriate number of chips comprising a material for either phase are embedded in a single phase target comprising a material for the other phase so that these chips appear in the target surface.

When the surface to be sputtered of the target is set upward in a vertical direction in the film-forming chamber of the film-forming apparatus, such a target that an appropriate number of chips comprising a material for either phase are placed simply on a single phase target comprising a material for the other phase, or such a target that a mixture of powdery materials for both phases is simply laid on a glass dish, can be employed. However, use of the powder target is not preferred in producing a semiconductor device because when the powder scatters in the film-forming environment, it affects adversely the semiconductor manufacturing process.

In the process for forming the charge retention layer by the sputtering method, the averaged particle diameter and the density of the dispersed phase growing in a matrix phase vary by controlling the composition of the target and the film-forming conditions. In particularly, it is confirmed that they vary depending on the volume fraction of the dispersed phase to the matrix phase, and film-forming conditions (such as Ar gas pressure in the sputtering, substrate temperature and so on). For example, when a film comprising nano-particles of Co metal dispersed in SiO₂ was formed by using a Co-SiO₂ type target, the particle size of Co particles was about 2 nm in a case of forming the film under the conditions that the volume ratio of Co to SiO₂ was 50:50 and the Ar gas pressure was 0.5 Pa, whereas the particle size of Co particles was about 5 nm in a case of forming the film under the condition that the Ar gas pressure was 8 Pa.

Further, when the volume ratio of Co and SiO₂ in the Co-SiO₂ type target was 23:77, the density was 1×10⁺¹³/cm² and the space distance between the outer shells of the particles was 0.9 nm. On the other hand, when the volume ratio was 10:90, the density was 7×10⁺¹²/cm² and the space distance between the outer shells of the particles was 1.8 nm. Thus, by adjusting the composition ratio of the target, it is possible to control the density of the nano-particles and the space distance between the outer shells of particles.

In order to carry out data-writing/erasing operations at a high speed or to increase controllability of the electric field distribution around the surface of the p-type semiconductor substrate 1 by applying a voltage to the control gate, the gate insulating film 4 should satisfy the following conditions. Namely, it is preferred to determine the film thickness and the materials so that the capacitive coupling between the control gate electrode 5 and the p-type semiconductor substrate 1 and the capacitive coupling between the control gate electrode 5 and the floating gates i.e. metal nano-particles 3a2. In particular, it is preferred to reduce the physical thickness and to select materials having high dielectric constant. Specifically, in the case of using a material having a thickness of at most 10 nm, the above-mentioned SiOₓN_{y} type material or a lamination film of SiO₂ and SiOₓN_{y} (where 0≦x<2 and 0<y≦4/3. In addition, it is preferred that x and y satisfy 2x+3y=4) is preferably used.

Into the charge retention layer of the nonvolatile semiconductor memory cell of the present invention, using a thin film comprising nano-particles made of a material having a work function or an electron affinity of at least 4.2 eV and having a particle size of at most 5 nm wherein the nano-particles are dispersed with high density in an amorphous insulator having an electron affinity of at most 1.0 eV, a large number of electric charges can be retained independently in a dispersed state and the ability of retaining electrons under circumstances of the room temperature or an elevated temperature is high. This high charge retention ability allows to reduce the thickness of the tunnel insulating film and the gate insulating film inserted between the charge retention layer and the control gate electrode. This structure is very useful in increasing the writing/erasing speed, reducing the driving voltage and downsizing and high integration of the cells.

Further, the charge retention layer of the nonvolatile semiconductor memory cell of the present invention employs a thin film comprising nano-particles made of a material having a work function rendering the difference of work function between such material and the semiconductor substrate or the control gate electrode to be at most 0.5 eV and having a particle size of at most 5 nm wherein the nano-particles are dispersed with high density in an amorphous insulator having an electron affinity of at most 1.0 eV. Accordingly, the charge retention layer can retain a large number of charges independently in a dispersed state and can suppress the reduction of the effective value of the energy barrier whereby the ability of retaining electrons under circumstances of the room temperature or an elevated temperature is extremely high. Such high charge retention ability allows to reduce the thickness of the tunnel insulating film and the insulating film inserted between the charge retention layer and the control gate electrode. This is very useful in increasing the writing/erasing speed, reducing the driving voltage and the scaling down and high integration of the cell.

In addition, the movement of the retained charges between adjacent nano-particles can be suppressed by dispersing the nano-particles so that the space distance between the outer shells of adjacent nano-particles in the charge retention layer is from 1 nm to 5 nm. This is very useful in increasing the performance of the cell, i.e. durability to the rewriting operations and stable multi-bits operations. Further, the movement of electric charges between adjacent nano-particles in the charge retention layer can also be suppressed because of the above-mentioned high charge retention performance. Accordingly, this is effective in improving rewriting operation and stable multi-bits operations.

Further, by employing the sputtering method for forming the charge retention layer, it is possible to select materials of various compositions for the dispersed phase and the matrix phase, and it is possible to incorporate easily a conventional semiconductor manufacturing process for the film-forming process. Accordingly, the nonvolatile semiconductor memory device of high performance can be produced with good reproducibility without changing significantly the conventional process.

In the following, several Examples will be described.

### EXAMPLE 1

The nonvolatile semiconductor memory cell according to this Example will be described with reference to Fig. 2. A tunnel insulating film 2 was formed on a p-type semiconductor substrate 1. The tunnel insulating film 2 is obtained by thermally oxidizing the semiconductor substrate at 800°C and it has a thickness of 5 nm.

Then, a charge retention layer 3, which was constituted from an insulating matrix 3b containing metal nano-particles 3a2, was formed so as to have a thickness of 5 nm by a capacitively coupled type magnetron sputtering method as described below. Co having a work function of 5.0 eV was selected for the metal nano-particles and amorphous SiO₂ having an electron affinity of 1.0 eV was selected for the insulating matrix. When the sputtering was carried out, a target which comprised a SiO₂ target having a diameter of 3 inches (7.62 cm) and Co chips having 5 mm square, placed thereon, was employed. The amount of Co chips was adjusted so as to occupy 20% of the vertical projection surface area of the target.

After evacuating the film forming chamber of the sputtering apparatus to 5×10⁻⁴ Pa, an Ar gas was supplied, and the gas flow rate was controlled so that the gas pressure in the film forming chamber became 0.5 Pa. Plasma was generated by supplying a high frequency power (13.56 MHz) of 200 W. The Co-SiO₂ composite film thus formed was observed with a TEM (transmission electron microscope). It was confirmed that Co crystal nano-particles having an average particle size of 2 nm were dispersed with an area density of 8×10¹²/cm² in the amorphous SiO₂. The space distance between the outer shells was estimated to be 1.6 nm.

After forming the SiO₂ film as the gate insulating film 4 on the Co-SiO₂ composite film, a film comprising tungsten nitride (W₂N) and tungsten was formed as the control gate electrode 5 on the gate insulating film by a sputtering method. Then, a SiO₂ film was formed to use it as a hard mask. A positive type photoresist was subjected to patterning to prepare a mask for gate etching. The SiO₂ hard mask was etched, and then, the control gate electrode 5 comprising the tungsten and the tungsten nitride, the gate insulating film 4 and the charge retention layer 3 were subjected to dry etching. Then, a source region 6 and a drain region 7 were formed by As ion implantation and annealing. After forming a protective film, contact holes were formed, and Al electrodes were formed for contact with the source region 6, the drain region 7 and the control gate electrode 5.

The memory cell having the Co-SiO₂ type charge retention layer thus prepared showed an extremely long charge retention time in comparison with each memory cell having Si nano-particles prepared by the same method, and showed a long retention time exceeding 20 years by the extrapolation of the measurement result. Further, it was confirmed that data of 2 bits were memorized per one memory cell.

### EXAMPLE 2

The nonvolatile semiconductor memory cell in this example will be described with reference to Fig. 3. A SOI (silicon on insulator) substrate having a p-type SOI layer 1a was used as the p-type semiconductor substrate 1. A mesa process was carried out for isolation, followed by boron (B) implantation for adjusting the threshold voltage. In this case, the work function of the p-type SOI layer 1a was estimated to be 4.95 eV. Then, a tunnel insulating film 2 was formed on the p-type SOI layer 1a. The tunnel insulating film 2 was obtained by thermal oxidation of the semiconductor substrate at 800°C and it had a thickness of 3 nm.

Then, a charge retention layer 3, which was constituted from an insulating matrix 3b containing metal nano-particles 3a2, was formed so as to have a thickness of 5 nm by a capacitively coupled type magnetron sputtering method as described below. Ru having a work function of 4.7 eV was selected for the metal nano-particles and AIN having a negative work function was selected for the insulating matrix. In this case, the difference between the work function of the p-type SOI substrate 1a and the work function of the nano-particles 3a2 is 0.25 eV. When the sputtering was carried out, a target obtained by sintering a mixture comprising a powder of highly pure Ru and powder of highly pure AlN in a proportion of 10:90 vol% was used.

After evacuating the film forming chamber of the sputtering apparatus to 5×10⁻⁴ Pa, an Ar gas was supplied, and the gas flow rate was adjusted so that the gas pressure in the film forming chamber becomes 0.5 Pa. Plasma was generated by supplying a high frequency power (13.56 MHz) of 200 W to form a Ru-AlN type charge retention layer in a thickness of 3 nm. In the evaluation of the film by TEM, it was confirmed that the Ru nano-particles having a size of 2 nm were dispersed with a density of 8×10⁺¹²/cm² in the amorphous AlN insulating matrix.

After forming a SiO₂ film as the gate insulating film 4 on the Ru-AlN composite film, a film of polycrystal Si was formed as the control gate electrode 5 by a low pressure CVD method. Then, a positive type photoresist was subjected to patterning to prepare a mask for gate etching, and the control gate electrode 5 comprising the polycrystal Si, the gate insulating film 4 and the charge retention layer 3 were subjected to dry etching.

After forming shallow junction regions 6a, 7a by implanting As ions with low energy, a SiO₂ film was formed by a low-pressure CVD. This SiO₂ film was subjected to etching anisotropically to form a side wall 8. Then, As ions were implanted more deeply to form contact regions 6b, 7b followed by RTA (rapid thermal annealing) whereby a source region 6 and a drain region 7 were formed. After forming a protective film, contact holes were formed and Al electrodes were formed to contact with the source region 6, the drain region 7 and the control gate electrode 5.

In the estimation of the height of the potential barrier with respect to electrons injected into Ru floating gates in the memory cell having the Ru-SiO₂ type charge retention layer thus prepared, it was found that it was about 3.7 eV which was substantially equal to the difference between the work function of Ru and the electron affinity of the oxide film. This fact shows that electrons are not injected in advance into the floating gates and there is no effective reduction of the height of the potential barrier. The height of the potential barrier was estimated from the tunnel leak speed of the electrons injected in the floating gates. The memory cell thus prepared showed an extremely long charge retention time, e.g., a charge retention time exceeding 20 years under circumstances of 250°C by the extrapolation of the measurement result, in comparison with such memory cell having Si nano-particles prepared by the same method. Further, it was confirmed that data of 2 bits could be memorized per one memory cell.

### INDUSTRIAL APPLICABILITY

The nonvolatile semiconductor memory device of the present invention can improve significantly the charge retention performance under circumstances of the room temperature or an elevated temperature in comparison with the same type of conventional memory devices, e.g., flash memories or Si nano-particle memories. As a result, the thickness of the tunnel insulating film and the gate insulating film adjacently contact on or above the charge retention layer can be reduced, whereby data-writing/erasing speed can be improved and the cell can be operated with a low voltage. Further, in downsizing of the cell, it is possible to reduce the size of the cell which has been difficult to realize in the above-mentioned conventional memory cell.

Further, according to the above-mentioned advantages of the nonvolatile semiconductor memory device of the present invention, use and application to various technical fields which were difficult by the conventional nonvolatile semiconductor memory devices, become possible. In particular, it is considered that a wide application for mobile personal terminal devices or nonvolatility of a personal computer-installed memory by replacing DRAM is possible.

The entire disclosures of Japanese Patent Application No. 2004-121837 filed on April 16, 2004, Japanese Patent Application No. 2004-129840 filed on April 26, 2004, Japanese Patent Application Nos. 2005-30859 and 2005-30860 filed on February 27, 2005 including specifications, claims, drawings and summaries are incorporated herein by reference in their entireties.

## Claims

1. A nonvolatile semiconductor memory cell comprising a source region and a drain region formed on a surface of a semiconductor substrate, a channel forming region formed to connect the source region to the drain region, or formed between the source region and the drain region, a tunnel insulating film formed in contact with the channel forming region, a charge retention layer formed adjacent the tunnel insulating film, a gate insulating film formed adjacent the charge retention layer and a control gate formed adjacent the gate insulating film, **characterized in that** the charge retention layer comprises an insulating matrix containing a single nano-particle of conductive substance per nonvolatile semiconductor memory cell or a plurality of nano-particles of conductive substance independently dispersed with a density of from 10⁺¹² to 10⁺¹⁴ particles per square centimeter of the charge retention layer, said nano-particle being made of at least one type of single-element substance or chemical compound that functions as floating gate and having a particle size of at most 5 nm, wherein the insulating matrix is amorphous and has an electron affinity of at most 1.0 eV and the work function of the nano-particle of conductive substance is at least 4.2 eV.

2. The nonvolatile semiconductor memory cell according to Claim 1, wherein the difference between the work function of the nano-particle and the work function of the semiconductor substrate is at most 0.5 eV.

3. The nonvolatile semiconductor memory cell according to Claim 1 or 2, wherein the difference between the work function of the nano-particle and the work function of the control gate is at most 0.5 eV.

4. The nonvolatile semiconductor memory cell according to Claim 1, 2 or 3, wherein the space distance between the outer shells of adjacent nano-particles is from 1 to 5 nm.

5. The nonvolatile semiconductor memory cell according to any one of Claims 1 to 4, wherein the melting point of the nano-particle is at least 1,400°C.

6. The nonvolatile semiconductor memory cell according to any one of Claims 1 to 5, wherein the difference in absolute value between the ionization energy level of an atom constituting the nano-particle in the semiconductor substrate and the energy level at the center of the forbidden band of the semiconductor substrate is at least 0.1 eV.

7. The nonvolatile semiconductor memory cell according to any one of Claims 1 to 6, wherein the nano-particle is at least one type of single substance or chemical compound selected from the group of elements consisting of W, Mo, Ti, Pt, Pd, Ni, Ta, Cr, Os, Nb, Ru and Rh.

8. The nonvolatile semiconductor memory cell according to any one of Claims 1 to 7, wherein the insulating matrix constituting the charge retention layer is made of at least one type of chemical compound selected from the group consisting of an oxide, a carbide, a nitride, a boride, a silicide and a fluoride.

9. The nonvolatile semiconductor memory cell according to any one of Claims 1 to 8, wherein the nano-particles constituting the charge retention layer are dispersed two-dimensionally or three-dimensionally in the insulating matrix.

10. A method for producing a nonvolatile semiconductor memory cell comprising the charge retention layer as described in Claim 9, in which nano-particles are dispersed two-dimensionally or three-dimensionally in the insulating matrix, **characterized in that** the charge retention layer is formed in a manner of self-organization by using a physical deposition method for depositing materials for the nano-particles and the insulating matrix respectively.

11. The method for producing a nonvolatile semiconductor memory cell according to Claim 10, wherein the physical deposition method is a sputtering method.

12. A nonvolatile semiconductor memory cell comprising a source region and a drain region formed on a surface of a semiconductor substrate, a channel forming region formed to connect the source region to the drain region, or formed between the source region and the drain region, a tunnel insulating film formed in contact with the channel forming region, a charge retention layer formed adjacent the tunnel insulating film, a gate insulating film formed adjacent the charge retention layer and a control gate formed adjacent the gate insulating film, **characterized in that** the charge retention layer comprises an insulating matrix containing a single nano-particle of semiconductor material or insulating material per nonvolatile semiconductor memory cell or a plurality of such nano-particles independently dispersed with a density of from 10⁺¹² to 10⁺¹⁴ particles per square centimeter of the charge retention layer, said nano-particle being made of at least one type of single-element substance or chemical compound that functions as a floating gate and having a particle size of at most 5 nm, wherein the insulating matrix is amorphous and has an electron affinity of at most 1.0 eV and the electron affinity of the nano-particle is at least 4.2 eV.

13. The nonvolatile semiconductor memory cell according to Claim 12, wherein the difference between the work function of the nano-particle and the work function of the semiconductor substrate is at most 0.5 eV.

14. The nonvolatile semiconductor memory cell according to Claim 12 or 13, wherein the difference between the work function of the nano-particle and the work function of the control gate is at most 0.5 eV.

15. The nonvolatile semiconductor memory cell according to Claim 12, 13 or 14, wherein the space distance between the outer shells of adjacent nano-particles is from 1 to 5 nm.

16. The nonvolatile semiconductor memory cell according to any one of Claims 12 to 15, wherein the melting point of the nano-particle is at least 1,400°C.

17. The nonvolatile semiconductor memory cell according to any one of Claims 12 to 16, wherein the difference in absolute value between the ionization energy of atoms constituting the nano-particle in the semiconductor substrate and the energy level at the center of the forbidden band of the semiconductor substrate is at least 0.1 eV.

18. The nonvolatile semiconductor memory cell according to any one of Claims 12 to 17, wherein the insulating matrix constituting the charge retention layer is made of at least one type of chemical compound selected from the group consisting of an oxide, a carbide, a nitride, a boride, a silicide and a fluoride.

19. The nonvolatile semiconductor memory cell according to any one of Claims 12 to 18, wherein the nano-particles constituting the charge retention layer are dispersed two-dimensionally or three-dimensionally in the insulating matrix.

20. A method for producing a nonvolatile semiconductor memory cell comprising the charge retention layer as described in Claim 19, in which nano-particles are dispersed two-dimensionally or three-dimensionally in the insulating matrix, **characterized in that** the charge retention layer is formed in a manner of self-organization by using a physical deposition method for depositing materials for the nano-particles and the insulating matrix respectively.

21. The method for producing a nonvolatile semiconductor memory cell according to Claim 20, wherein the physical deposition method is a sputtering method.
